(19) Europäisches Patentamt / European Patent Office / Office européen des brevets

(11) **EP 4 734 413 A1**

(12) **DEMANDE DE BREVET EUROPEEN**

(43) Date de publication:
**29.04.2026 Bulletin 2026/18**

(21) Numéro de dépôt: **25210940.0**

(22) Date de dépôt: **24.10.2025**

(51) Classification Internationale des Brevets (IPC):
***H04L 1/00*** *(2006.01)* ***H03M 13/27*** *(2006.01)*

(52) Classification Coopérative des Brevets (CPC):
**H04L 1/0071; H03M 13/2732**

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**
Etats d'extension désignés:
**BA**
Etats de validation désignés:
**GE KH LA MA MD TN**

(30) Priorité: **25.10.2024 FR 2411705**

(71) Demandeur: **THALES**
**92190 Meudon (FR)**

(72) Inventeurs:
• **MESNAGER, GILLES MAURICE CHARLES**
**31100 TOULOUSE (FR)**
• **FAVARO, Henri**
**31100 TOULOUSE (FR)**

(74) Mandataire: **Lavoix**
**2, place d'Estienne d'Orves**
**75441 Paris Cedex 09 (FR)**

(54) **MÉTHODE ET DISPOSITIF D'ENTRELACEMENT**

(57) La présente invention concerne un émetteur (12) de signaux représentatifs de données numériques d'entrée (De), comprenant un module de traitement numérique (16) comprenant :
- un premier entrelaceur (21) configuré pour recevoir successivement des trames de données d'entrée (Te), représentatives des données numériques d'entrée (De) pour les séparer en mots, et pour entrelacer les mots des trames de données d'entrée (Te) entre eux selon une première logique afin de former des premières trames de données entrelacées (T1) ; et
- un deuxième entrelaceur (22), configuré pour recevoir les premières trames de données entrelacées (T1), pour les séparer en mots et pour entrelacer les mots des premières trames de données entrelacées (T1) entre eux selon une deuxième logique afin de former des deuxièmes trames de données entrelacées (T2),
l'émetteur (12) comprenant en outre un module d'émission (18) configuré pour émettre les signaux.

FIG.3

EP 4 734 413 A1

**Description**

La présente invention concerne un émetteur, un récepteur, une chaîne de transmission, et un procédé de transmission de données associées.

Il est connu d'utiliser des technologies fonctionnant par radiofréquences pour assurer les transmissions de données. Les technologies optiques sont également une alternative intéressante aux technologies fonctionnant par radiofréquences. En particulier, les communications optiques, notamment en espace libre bord-sol, sont une solution prometteuse pour augmenter les débits de transmission.

Cependant, les milieux de transmission utilisés dans les technologies radiofréquence ou optiques présentent plusieurs inconvénients, en particulier, la dégradation du signal transmis. Notamment, les transmissions optiques souffrent d'une forte dégradation du signal à cause de la composition variable des couches de l'atmosphère et des turbulences. Ces phénomènes causent des évanouissements profonds, interrompant ainsi la transmission entre un émetteur et un récepteur pendant plusieurs millisecondes. Les trames de données transmises étant de durée inférieure à plusieurs millisecondes, un tel évanouissement peut causer la perte des informations contenues dans ces trames de données.

Afin de limiter la perte d'information pendant ces évanouissements, il est nécessaire d'étaler les informations portées par les trames de données sur une durée supérieure à la durée de l'évanouissement. Cette opération est réalisée notamment en utilisant une fonction d'entrelacement des trames de données. Dans ce cas, un évanouissement de la durée d'une trame provoquera, à la place d'une trame entièrement perdue, la dispersion des pertes d'information sur plusieurs trames. Il est possible de récupérer ces informations à l'aide par exemple de codes correcteurs d'erreurs, et donc d'éviter les pertes d'informations causées par les évanouissements.

Cependant, l'entrelacement effectué actuellement est complexe et demande des ressources importantes. De plus, l'entrelacement effectué actuellement ne permet pas toujours d'étaler les trames de données sur une durée suffisamment importante pour éviter les pertes complètes d'information.

Le but de l'invention est alors d'améliorer la transmission d'un signal pour limiter les pertes de données, de manière simple.

A cet effet, l'invention a pour objet un émetteur de signaux représentatifs de données numériques d'entrée, comprenant un module de traitement numérique comprenant :

- un premier entrelaceur configuré pour recevoir successivement des trames de données d'entrée, représentatives des données numériques d'entrée, pour les séparer en mots, et pour entrelacer les mots des trames de données d'entrée entre eux selon une première logique afin de former des premières trames de données entrelacées ; et

- un deuxième entrelaceur, configuré pour recevoir les premières trames de données entrelacées, pour les séparer en mots et pour entrelacer les mots des premières trames de données entrelacées entre eux selon une deuxième logique afin de former des deuxièmes trames de données entrelacées,

l'émetteur comprenant en outre un module d'émission configuré pour émettre les signaux.

Grâce à l'invention, les trames de données sont entrelacées en deux fois, ce qui permet d'augmenter la durée sur laquelle les trames de données sont entrelacées, tout en permettant un entrelacement fin des trames de données. Ceci permet de diminuer à la fois la quantité de données perdues lors d'un évanouissement, et de supporter des évanouissements de durée plus longue.

Par exemple, le premier entrelaceur forme des premières trames de données entrelacées sur des faibles durées, mais qui permettent une répartition optimale des données, et donc un entrelacement de bonne qualité. Notamment, les mots formés par le premier entrelaceur sont des mots comprenant une faible quantité de données, les premières trames de données sont donc entrelacées finement, afin de bien répartir les données contenues dans les trames, et limiter la perte d'information. Le deuxième entrelaceur sépare par exemple les premières trames de données entrelacées en mots de taille importante, ce qui permet d'entrelacer les mots sur des durées importantes afin de limiter la perte d'information en cas d'évanouissement profond.

De manière plus générale, l'invention permet d'entrelacer plus facilement les trames de données en fonction des besoins de l'utilisateur, et notamment sur des durées plus longues, sans impact sur la qualité de l'entrelacement.

Suivant d'autres aspects avantageux de l'invention, l'émetteur comprend une ou plusieurs des caractéristiques suivantes, prises isolément ou suivant toutes les combinaisons techniquement possibles :

- La première et la deuxième logique sont des logiques de convolution, et chaque entrelaceur a les paramètres suivants :
- un nombre de branches prédéterminé définissant une profondeur d'entrelacement ; et
- une taille des trames de données entrelacées émises par l'entrelaceur, exprimée en nombre de mots.
- Les deux entrelaceurs ont une profondeur d'entrelacement égale.
- Le deuxième entrelaceur est configuré pour séparer les premières trames de données entrelacées émises par le premier entrelaceur en mots dont une taille, exprimée en bits, égale à la taille des premières trames de données entrelacées, exprimée en bits.
- Le deuxième entrelaceur comprend une mémoire, une taille de la mémoire en nombre de bits étant égale à la moitié du produit entre la profondeur du deuxième entrelaceur, la taille des deuxièmes trames de données entrelacées et la taille de chaque mot formant les deuxièmes trames de données entrelacées en nombre de bits.

- Le deuxième entrelaceur comprend une mémoire de type débit de données double.
- Chaque entrelaceur est configuré pour séparer les trames de données qu'il reçoit en mots formés d'au moins un bit.
- Le module de traitement numérique comprend en outre une unité de codage canal, configurée pour recevoir les données numériques d'entrée, et pour convertir les données numériques d'entrée en trames de données d'entrée, les trames de données d'entrée étant représentatives des données numériques d'entrée.

L'invention concerne également un récepteur comprenant un module de réception configuré pour recevoir un signal émis par un émetteur ainsi que décrit précédemment, le récepteur comprenant en outre un module de traitement numérique comprenant :

- un premier désentrelaceur, configuré pour recevoir successivement des trames de données reçues, les trames de données reçues étant représentatives du signal émis par l'émetteur, pour séparer les trames de données reçues en mots et pour désentrelacer les mots des trames de données reçues selon la deuxième logique afin de former des premières trames de données désentrelacées ;
- un deuxième désentrelaceur, configuré pour recevoir successivement les premières trames de données désentrelacées, pour séparer les premières trames de données désentrelacées en mots et pour désentrelacer les mots des premières trames de données désentrelacées selon la première logique afin de former des deuxièmes trames de données désentrelacées.

L'invention concerne également une chaîne de transmission comprenant un émetteur et un récepteur ainsi que décrits précédemment.

L'invention concerne également un procédé de transmission de données, mis en œuvre par une chaîne de transmission ainsi que décrite précédemment, le procédé comprenant au moins les étapes suivantes :

- traitement, par le premier entrelaceur, des trames de données d'entrée reçues successivement, le traitement comprenant une sous étape de séparation des trames de données d'entrée en mots et une sous étape d'entrelacement des mots des trames de données d'entrée entre eux selon la première logique pour former les premières trames de données entrelacées ;

- réception successive par le deuxième entrelaceur, des premières trames de données entrelacées ;
- traitement, par le deuxième entrelaceur, le traitement comprenant une sous-étape de séparation des premières trames entrelacées en mots et une sous-étape d'entrelacement des mots des premières trames de données entrelacées entre eux selon la deuxième logique pour former les deuxièmes trames de données entrelacées ;
- émission par le module d'émission du signal représentatif des données numériques d'entrée ;
- réception par le module de réception du signal et conversion en trames de données reçues ;
- traitement, par le premier désentrelaceur, des trames de données reçues successivement, le traitement comprenant une sous-étape de séparation des trames de données reçues en mots et une sous-étape de désentrelacement des mots des trames de données reçues selon la deuxième logique pour former les premières trames de données désentrelacées ;
- réception successive par le deuxième désentrelaceur des premières trames de données désentrelacées ; et
- traitement, par le deuxième désentrelaceur, des premières trames de données désentrelacées, le traitement comprenant une sous-étape de séparation des premières trames désentrelacées en mots et une sous-étape de désentrelacement des mots des premières trames de données désentrelacées selon la première logique pour former les deuxièmes trames de données désentrelacées.

L'invention apparaîtra plus clairement à la lecture de la description qui va suivre, donnée uniquement à titre d'exemple non limitatif, et faite en référence aux dessins dans lesquels :

- [Fig. 1] la figure 1 est une représentation d'une chaîne de transmission selon l'invention ;
- [Fig. 2] la figure 2 est un schéma bloc de la chaîne de transmission de la figure 1 ;
- [Fig. 3] la figure 3 est un schéma d'un entrelacement réalisé par un émetteur de la chaîne de transmission de la figure 2 ;
- [Fig. 4] la figure 4 est un schéma d'un entrelaceur et d'un désentrelaceur de la chaîne de transmission de la figure 2 ; et
- [Fig. 5] la figure 5 est un logigramme d'un procédé de transmission de données selon l'invention.

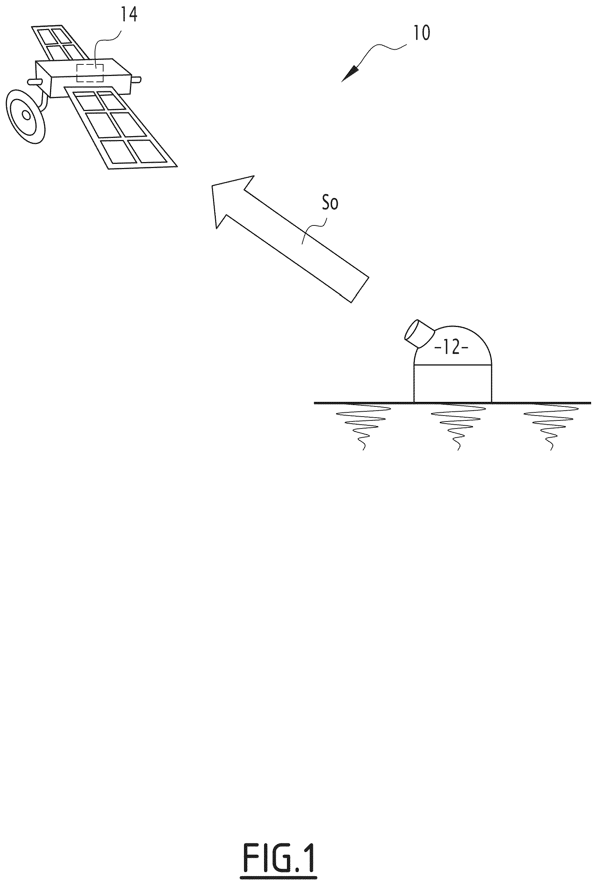

La figure 1 représente une chaîne de transmission 10 selon l'invention. La chaîne de transmission 10 comprend un émetteur 12 et un récepteur 14. La chaîne de transmission 10 est une chaîne de transmission optique, ou en variante non représentée, de radiofréquences.

L'émetteur 12 est avantageusement disposé au sol, par exemple dans une station de télécommunications.

Le récepteur 14 est avantageusement embarqué dans un aéronef ou un satellite.

En variante, c'est l'émetteur 12 qui est embarqué dans un aéronef ou un satellite, et le récepteur 14 qui est au sol, par exemple dans une station de télécommunication. En variante encore, l'émetteur 12 et le récepteur 14 sont tous les deux au sol.

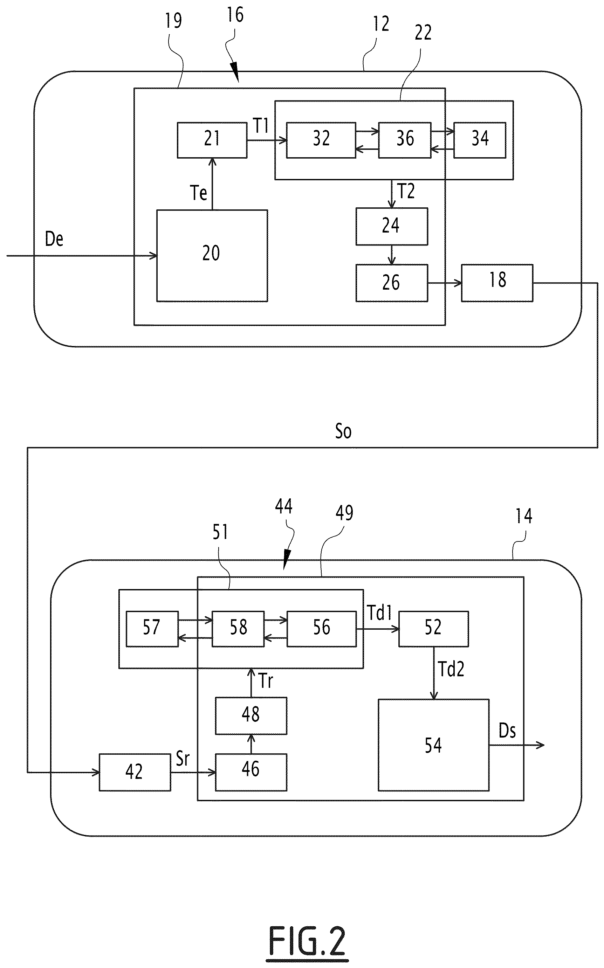

Comme cela est représenté sur la figure 2, l'émetteur 12 comprend un module de traitement numérique 16 et, avantageusement, un module d'émission 18, connecté au module de traitement numérique 16.

Le module de traitement numérique 16 est par exemple réalisé partiellement ou totalement sous la forme d'un composant logique programmable, tel qu'un FPGA 19, de l'anglais « Field Programmable Gate Array », ainsi que représenté à la figure 2. En variante non représentée, le module de traitement numérique 16 est réalisé sous la forme d'un circuit intégré tel qu'un ASIC, de l'anglais « Application Specific Integrated Circuit ». En variante ou en complément, le module de traitement numérique 16 est réalisé au moins partiellement sous la forme d'un ou de plusieurs logiciels stockés dans une mémoire et exécutables par un processeur associé à la mémoire.

Le module de traitement numérique 16 comprend avantageusement une unité de codage canal 20. Le module de traitement numérique 16 comprend en outre un premier entrelaceur 21, un deuxième entrelaceur 22 connecté en sortie du premier entrelaceur 21, et avantageusement une unité de synchronisation 24, connectée en sortie du deuxième entrelaceur 22, et une unité de génération de symboles modulés 26, connectée en sortie de l'unité de synchronisation 24.

L'unité de codage canal 20 est configurée pour convertir des données numériques d'entrée De en trames de données d'entrée Te, représentatives des données numériques d'entrée De. Les données numériques sont par exemple des données d'observation issues de capteurs, des données audio ou encore des images, ou plus généralement des données issues d'un nœud de télécommunications numériques.

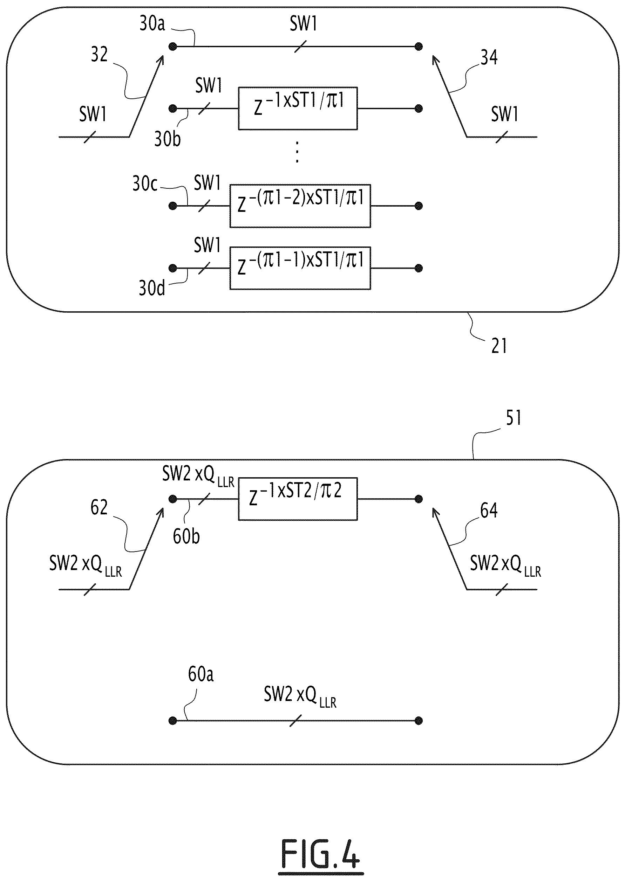

Le premier entrelaceur 21, représenté à la figure 4, est configuré pour recevoir successivement les trames de données d'entrée Te, pour les séparer en mots, et pour entrelacer les mots des trames de données d'entrée Te entre eux selon une première logique afin de former des premières trames de données entrelacées T1.

Le premier entrelaceur 21 est un entrelaceur convolutionnel et fonctionne selon une logique de convolution. La première logique est donc une logique de convolution.

En variante, le premier entrelaceur 21 est un entrelaceur bloc et fonctionne selon une logique de bloc.

Avantageusement, les mots sont formés de SW1 bits, SW1 étant un nombre prédéfini. Les trames ont une taille ST1, exprimée en nombre de mots. Avantageusement, les premières trames de données entrelacées T1 émises par le premier entrelaceur 21 sont formées de mots constitués chacun d'un bit, autrement dit, SW1=1 bit. Ainsi, dans ce cas, les premières trames de données entrelacées T1 sont formées de ST1 mots, d'un bit chacun.

La taille ST1 des premières trames de données entrelacées T1, et la taille SW1 des mots des premières trames de données entrelacées T1 sont avantageusement des paramètres du premier entrelaceur 21, et sont avantageusement définies par un utilisateur.

Le premier entrelaceur 21 comprend avantageusement un nombre de branches prédéterminé, un pointeur d'entrée 32 et un pointeur de sortie 34.

Ainsi que visible à la figure 4, le premier entrelaceur 21 comprend quatre branches 30a à 30d. En variante, le premier entrelaceur 21 comprend plus que quatre branches. Le nombre de branches est prédéterminé et définit une profondeur d'entrelacement $\pi1$, qui est un autre paramètre du premier entrelaceur 21. La profondeur d'entrelacement $\pi1$ est égale au nombre de branches, et est supérieure ou égale à deux. Ainsi, la profondeur $\pi1$ est égale à quatre pour le premier entrelaceur 21. Le premier entrelaceur 21 a ainsi les paramètres suivants : une taille ST1 des premières trames de données entrelacées T1, une taille SW1 des mots formant les premières trames de données entrelacées T1 et une profondeur d'entrelacement $\pi1$.

Chaque branche 30a à 30d comprend un registre à retard, configuré pour retarder un mot reçu d'une durée prédéfinie, égale à un multiple d'un retard $z^{-ST1/\pi1}$. En pratique, les registres à retard sont implémentés dans une mémoire, sont intégrés au FPGA 19. Le fonctionnement du premier entrelaceur 21 est décrit en détail par la suite.

Le deuxième entrelaceur 22 est configuré pour recevoir les premières trames de données entrelacées T1, pour les séparer en mots et pour entrelacer les mots des premières trames de données entrelacées T1 entre eux selon une deuxième logique afin de former des deuxièmes trames de données entrelacées T2.

Le deuxième entrelaceur 22 est un entrelaceur convolutionnel et fonctionne selon une logique de convolution. La deuxième logique est donc une logique de convolution.

En variante, le deuxième entrelaceur 22 est un entrelaceur bloc.

Avantageusement, les mots sont formés d'au moins un bit. Ainsi, chaque mot a une taille SW2, exprimée en nombre de bits. Dans le cas des deuxièmes trames de données entrelacées T2, avantageusement, chaque mot est formé de SW2 bits.

Avantageusement, les deuxièmes trames de données entrelacées T2 émises par le deuxième entrelaceur 22 ont une taille ST2, exprimée en nombre de mots. Autrement dit, les deuxièmes trames de données entrelacées T2 sont formées de ST2 mots.

Ainsi, dans ce cas, chaque deuxième trame de données entrelacées T2 comprend ST2 mots de SW2 bits chacun.

La taille ST2 des deuxièmes trames de données entrelacées T2 et la taille SW2 des mots des deuxièmes trames de données entrelacées T2 sont avantageusement des paramètres du deuxième entrelaceur 22, et sont avantageusement définis par l'utilisateur.

Le deuxième entrelaceur 22 comprend un nombre de branches prédéterminé, définissant une profondeur $\pi 2$. Par exemple, le deuxième entrelaceur 22 comprend deux branches, ainsi, sa profondeur d'entrelacement $\pi 2$ est égale à deux. En variante, la profondeur $\pi 2$ est supérieure à deux. Chaque branche du deuxième entrelaceur 22 comprend un registre à retard, configuré pour retarder un mot reçu d'une durée prédéfinie, égale à un multiple d'un retard $z^{-ST2/\pi 2}$.

En variante non représentée, les deux entrelaceurs 21 et 22 ont le même nombre de branches, autrement dit, la même profondeur d'entrelacement, c'est-à-dire $\pi 1 = \pi 2$.

Le deuxième entrelaceur 22 a ainsi les paramètres suivants : une taille ST2 des deuxièmes trames de données entrelacées T2, exprimée en nombre de mots, une taille SW2 des mots formant les deuxièmes trames de données entrelacées T2, exprimée en nombre de bits, et une profondeur d'entrelacement $\pi 2$.

En pratique, le deuxième entrelaceur 22 est implémenté sous la forme d'une unité de séquencement 32, d'une mémoire 34 et d'un contrôleur mémoire 36, connecté entre l'unité de séquencement 32 et la mémoire 34, incluses dans le deuxième entrelaceur 22.

Les registres à retard sont implémentés dans la mémoire 34.

Avantageusement, la mémoire 34 du deuxième entrelaceur 22 est une mémoire de type débit de données double, ou DDR, de l'anglais « Double Data Rate ». Dans ce cas, l'ensemble de l'unité de traitement numérique 16 sauf la mémoire 34 est avantageusement implémentée dans le FPGA 19, la mémoire 34 étant implémentée dans un composant spécifique, ainsi que représenté à la figure 2.

Une taille minimale de la mémoire DDR 34, en nombre de bits, est égale à la moitié du produit entre la profondeur d'entrelacement $\pi 2$ du deuxième entrelaceur 22, la taille ST2 des deuxièmes trames de données entrelacées T2 et la taille SW2 de chaque mot formant les deuxièmes trames de données entrelacées T2. Autrement dit, la taille minimale de la mémoire $S_{DDR}$ est exprimée selon l'équation suivante :

$$S_{DDR} = \frac{1}{2} \times \pi 2 \times ST2 \times SW2$$

Ainsi, avantageusement, la taille de la mémoire DDR 34 est choisie comme étant égale à la taille minimale.

Le contrôleur mémoire 36 est configuré pour effectuer les accès mémoire lors du fonctionnement du deuxième l'entrelaceur 22.

L'unité de synchronisation 24 est configuré pour réaliser l'insertion de mots uniques permettant au récepteur 14, de détecter le début de trames entrelacées qu'il reçoit, avant de réaliser une opération de désentrelacement, expliquée en détail par la suite.

L'unité de génération 26 est configurée pour adapter les deuxièmes trames entrelacées T2 à un type de modulation prédéfini. En particulier, l'unité de génération 26 est configurée pour allouer à un symbole modulé un nombre de bits issu des deuxièmes trames de données entrelacées T2. Par exemple pour une modulation à deux états, un bit issu d'une deuxième trame de données entrelacées T2 est associé à un bit de modulation, autrement dit, à un symbole modulé composé d'un bit. Pour une modulation à quatre états, deux bits issus d'une deuxième trame de données entrelacées T2 sont associés à un symbole modulé composé de deux bits.

Le module d'émission 18 comprend par exemple un modulateur 18 optique, comme un interféromètre de Mach-Zehnder. Le module d'émission 18 est avantageusement configuré pour émettre des signaux représentatifs des deuxièmes trames de données entrelacées T2. Les signaux sont ainsi représentatifs des données d'entrée De. Les signaux sont ici des signaux optiques So.

En variante, dans le cas où la chaîne de transmission 10 est une chaîne de transmission radiofréquences, le modulateur 18 est un modulateur de radiofréquences et les signaux sont des signaux radiofréquence.

Le récepteur 14 comprend avantageusement un module de réception 42 et un module de traitement numérique 44, connecté au module de réception 42. Avantageusement, le module de réception 42 comprend un démodulateur optique.

En variante non représentée, dans le cas où la chaîne de transmission 10 est une chaîne de transmission radiofréquences, le démodulateur est un démodulateur de radiofréquences.

Le module de réception 42 est avantageusement configuré pour recevoir le signal optique So émis par l'émetteur 12 et pour le démoduler afin de le convertir en signaux numériques démodulés, dit aussi signaux numériques reçus Sr, représentatif du signal optique So émis par l'émetteur 12.

Le module de traitement numérique 44, de manière similaire au module de traitement numérique 16, est avantageusement réalisé, intégralement ou partiellement, sous la forme d'un composant logique programmable tel qu'un FPGA 49.

En variante non représentée ou en complément, le module de traitement numérique 44 est réalisé au moins partiellement sous la forme d'un circuit intégré, tel un ASIC ou d'un ou de plusieurs logiciels stockés dans une mémoire et exécutables par un processeur associé à la mémoire.

Le module de traitement numérique 44 comprend avantageusement une unité de restitution des mots entrelacés à partir des symboles modulés 46, connectée en sortie à une unité de synchronisation 48. Le module de traitement numérique 44 comprend un premier désentrelaceur 51 connecté en sortie à un deuxième désentrelaceur 52, et avantageusement, une unité de décodage canal 54, connectée en sortie du deuxième désentrelaceur 52. L'unité de restitution des mots entrelacés à partir des symboles modulés 46, l'unité de synchronisation 48, le premier désentrelaceur 51, le deuxième désentrelaceur 52, et l'unité de décodage canal 54 correspondent respectivement à l'unité de génération 26 des symboles modulés à partir des mots entrelacés, l'unité de synchronisation 24, le deuxième entrelaceur 22, le premier entrelaceur 21, et l'unité de codage canal 20.

L'unité de restitution 46 des mots entrelacés à partir des symboles modulés 46 est avantageusement configurée pour recevoir les signaux numériques démodulés Sr, et pour convertir les symboles démodulés en rapport de vraisemblance ou LLR, de l'anglais « Log Likelihood Ratio », afin de former à nouveau des trames de données entrelacées correspondant aux deuxièmes trames de données entrelacées T2 et aux mots uniques ajoutés par l'unité de synchronisation 24.

L'unité de synchronisation 48 est configurée pour détecter le début des trames de données entrelacées en détectant les mots uniques. L'unité de synchronisation 48 est en outre configurée pour éliminer les mots uniques insérés lors de l'émission par l'unité de synchronisation 24 et pour émettre à la place un signal de début de trame directement vers l'unité de désentrelacement 51. L'unité de synchronisation 48 est ainsi configurée pour former des trames de données entrelacées et synchronisées, ou trames reçues Tr à destination du premier désentrelaceur 51.

De manière avantageuse, l'unité de restitution 46 est configurée pour convertir les symboles modulés en rapport de vraisemblance, ou LLR, codé sur $Q_{LLR}$ bits. Ainsi, en sortie de l'unité de synchronisation 48, chaque trame reçue Tr, qui correspond aux deuxièmes trames de données entrelacées T2, comprend ST2 mots, et chaque mot est codé sur $SW2 \times Q_{LLR}$ bits, et non pas SW2 bits.

Le premier désentrelaceur 51 est représenté à la figure 4, et est configuré pour recevoir successivement des trames de données reçues Tr, pour les séparer en mots et pour désentrelacer les mots des trames de données reçues Tr selon la deuxième logique afin de former des premières trames de données désentrelacées Td1. Autrement dit, le premier désentrelaceur 51 est configuré pour effectuer l'opération inverse du deuxième entrelaceur 22.

Le deuxième entrelaceur 22 et le premier désentrelaceur 51 ont la même logique. Ainsi, le premier désentrelaceur 51 est un désentrelaceur convolutionnel. Le premier désentrelaceur 51 comprend π2=2 branches, 60a et 60b, un pointeur d'entrée 62 et un pointeur de sortie 64.

Ainsi, le premier désentrelaceur 51 a la même profondeur d'entrelacement π2 et la même taille ST2 de trames de données désentrelacées émises que le deuxième entrelaceur 22.

Chaque branche 60a à 60d comprend un registre à retard, configuré pour retarder un mot reçu d'une durée prédéfinie égale à un multiple d'un retard $z^{-ST2/\pi2}$. Dans le cas de la branche 60a, ce retard vaut zéro.

En pratique, le premier désentrelaceur 51 est implémenté sous la forme d'une unité de séquencement 56, d'une mémoire 57 et d'un contrôleur mémoire 58, connecté entre l'unité de séquencement 56 et la mémoire 57, inclues dans le premier désentrelaceur 51, de manière similaire à ce qui a été décrit pour le deuxième entrelaceur 22. Les registres à retard sont en pratique implémentés dans la mémoire 57.

Avantageusement, la mémoire 57 est une mémoire DDR, dont la taille minimale $S_{DDR}'$, en bits, est avantageusement égale à :

$$S_{DDR}' = \frac{1}{2} \times \pi2 \times ST2 \times SW2 \times Q_{LLR}$$

Dans ce cas, l'ensemble de l'unité de traitement numérique 44 sauf la mémoire 57 est avantageusement implémentée dans le FPGA 49, la mémoire 57 étant avantageusement implémentée dans un composant spécifique, ainsi que représenté à la figure 2.

Le deuxième désentrelaceur 52 est configuré pour recevoir successivement les premières trames de données désentrelacées Td1, pour séparer les premières trames de données désentrelacées Td1 en mots et pour désentrelacer les mots des premières trames de données désentrelacées Td1 selon la première logique afin de former des deuxièmes trames de données désentrelacées Td2. Autrement dit, le deuxième désentrelaceur 52 est configuré pour effectuer l'opération inverse du premier entrelaceur 21.

En particulier, de manière avantageuse, les deuxièmes trames de données désentrelacées Td2 formées par le deuxième désentrelaceur 52 comprennent des mots de $SW1 \times Q_{LLR}$ bit. Une taille des deuxièmes trames de données désentrelacées Td2 émises par le deuxième désentrelaceur 52, exprimée en nombre de mots, est égale à ST1. Les deuxièmes trames de données désentrelacées Td2 formées par le deuxième désentrelaceur 52 sont donc de taille $ST1 \times SW1 \times Q_{LLR}$ bits.

Le premier entrelaceur 21 et le deuxième désentrelaceur 52 ont la même logique, ainsi, dans le cas où le premier entrelaceur 21 est un entrelaceur convolutionnel, le deuxième désentrelaceur 52 est un désentrelaceur convolutionnel.

En variante non représentée, le premier entrelaceur 21 et le deuxième désentrelaceur 52 ont tous les deux une logique de bloc, et sont donc un entrelaceur et un désentrelaceur bloc.

Le deuxième désentrelaceur 52 comprend $\pi 1 = 4$ branches, chaque branche comprenant un registre à retard de manière similaire aux branches 30a à 30d. Le deuxième désentrelaceur 52 a ainsi la même profondeur d'entrelacement $\pi 1$ et la même taille ST1 des trames de données désentrelacées émises que le premier entrelaceur 21.

L'unité de décodage canal 54 est configurée pour recevoir les deuxièmes trames de données entrelacées Td2 et pour les convertir en données numériques de sortie Ds, représentative des données d'entrée De.

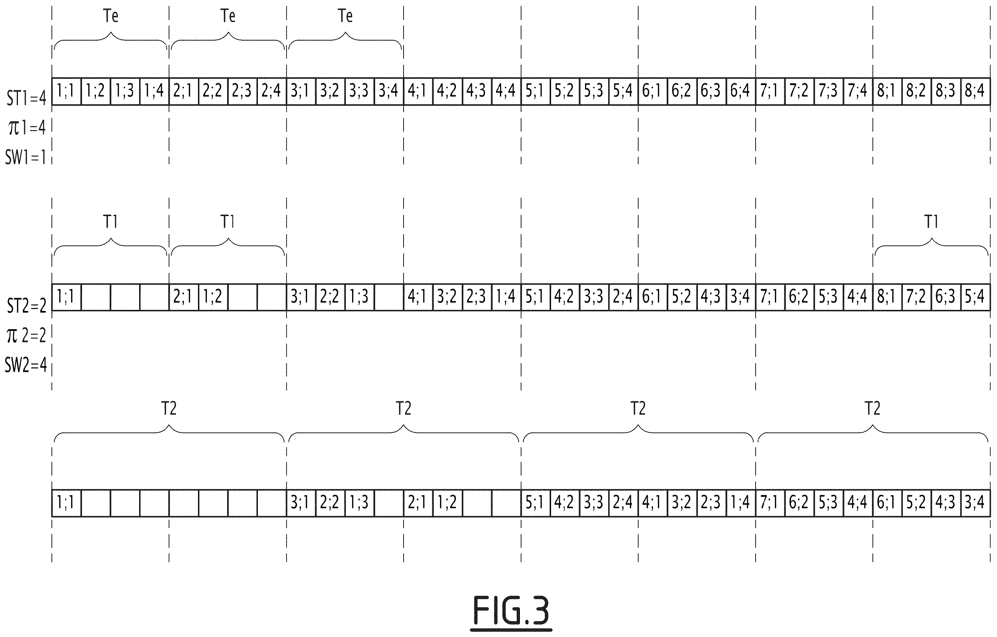

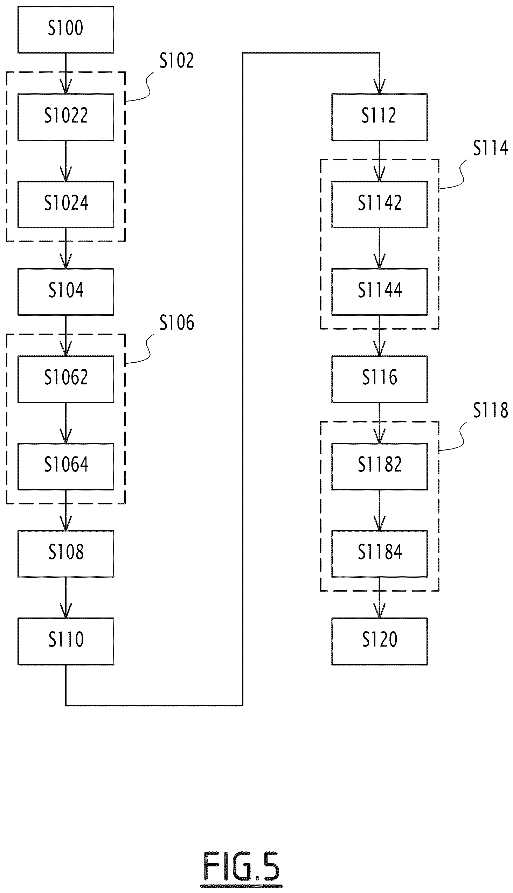

Un procédé de transmission de données est maintenant expliqué, en regard des figures 3 à 5.

Lors d'une étape S100, l'unité de codage canal 20 convertit les données numériques d'entrée De en trames de données d'entrée Te. Pour cela, avantageusement, l'unité de codage canal 20 implémente des codes de correction d'erreurs, par exemple des codes de parité à faible densité, ou LDPC, de l'anglais « Low Parity Density Codes ».

Le premier entrelaceur 21 traite les trames de données d'entrée Te reçues successivement lors d'une étape S102. L'étape de traitement S102 comprend les sous-étapes S1022 et S1024. La sous-étape S1022 est une sous-étape de séparation des trames de données d'entrée Te en mots de taille SW1 bits. La sous-étape S1024 est une sous-étape d'entrelacement des mots formés par séparation des trames de données d'entrée Te entre eux selon la première logique pour former les premières trames de données entrelacées T1.

Le fait que le premier entrelaceur 21 soit convolutif impose que la taille ST1 des premières trames de données entrelacées T1 soit égale à un multiple de $\pi 1$. Dans l'exemple des figures 3 et 4, ST1 et $\pi 1$ valent tous les deux quatre.

Lors de la sous-étape S1024, les mots formant une trame de donnée d'entrée Te sont successivement envoyés dans les branches 30a à 30d. Le choix de la branche est imposé par le pointeur 32. Le pointeur d'entrée 32 parcourt successivement chaque branche, avantageusement en commençant par la branche 30a puis successivement 30b, 30c et 30d, avant de recommencer avec la branche 30a. Ainsi, le premier mot de la trame de données d'entrées Te est envoyé dans la branche 30a, le deuxième dans la branche 30b, etc.

Le premier entrelaceur 21 fonctionne à une fréquence d'horloge « mot » prédéterminée, de période $T_h$. Ainsi, un mot est envoyé dans l'une des branches 30a à 30d à chaque période $T_h$. Autrement dit, le pointeur 32 change de branche tous les $T_h$.

Une fois qu'un mot est envoyé dans l'une des branches 30a à 30d, le mot passe dans un registre à retard, et est ainsi retardé d'un multiple du retard $z^{-S_{T1}/\pi_1}$ qui correspond à une durée nécessaire pour que le pointeur d'entrée 32 parcoure toutes les branches 30a à 30d, autrement dit $\pi 1 \times T_h$. Ainsi, la branche 30a ne retarde pas le mot reçu, la branche 30b retarde le mot reçu du retard $z^{-S_{T1}/\pi_1}$, la branche 30c retarde le mot reçu de deux fois le retard $z^{-S_{T1}/\pi_1}$ et la branche 30d retarde le mot reçu de trois fois le retard $z^{-S_{T1}/\pi_1}$.

Le pointeur de sortie 34 lit les mots sur chaque branche 30a à 30d, et son déplacement est synchronisé avec celui du pointeur d'entrée 32 afin de lire les mots après qu'ils ont été retardés par le passage dans les registres à retard des branches 30a à 30d.

L'entrelacement des mots est représenté à la figure 3. Chaque case représente un mot, les trames de données d'entrée Te sont séparées en mots formées d'un bit chacun et les premières trames de données entrelacées T1 sont formées de mots issus de la trame courante et des ($\pi 1 -1$) trames précédente. Pour faciliter la compréhension, on représente les données d'entrée Te séparées en trames composées de mots, un mot correspondant à une case, et on représente un cas où une trame de données d'entrée Te comprend quatre mots, les trames de données d'entrée Te étant délimitées par les pointillés.

A cause du passage dans les registres à retard, le premier mot de coordonnées (1 ; 1) est envoyé dans la branche 30a, n'est pas retardé, et devient donc le premier mot de la première trame T1. Le deuxième mot de coordonnées (1 ; 2) est envoyé dans la branche 30b, est retardé du retard $z^{-S_{T1}/\pi_1}$ et devient donc le deuxième mot de la première trame de données entrelacées T1 suivante. Le troisième mot de coordonnées (1 ; 3) est envoyé dans la branche 30c, est retardé de deux fois le retard $z^{-3_{T1}/\pi_1}$ et devient donc le troisième mot de la première trame de données entrelacées T1 encore suivante. Une fois que chaque branche 30a à 30d est parcourue, le pointeur d'entrée 32 revient à la branche 30a et effectue à nouveau le processus.

Ainsi, dans l'exemple de la figure 3, chaque premier mot est envoyé dans la branche 30a et n'est pas retardé, chaque deuxième mot est envoyé dans la branche 30b et est retardé du retard $z^{-3_{T1}/\pi_1}$, chaque troisième mot est envoyé dans la branche 30c et est retardé de deux fois le retard $z^{-S_{T1}/\pi_1}$ et chaque quatrième mot est envoyé dans la branche 30d et est retardé de trois fois le retard $z^{-S_{T1}/\pi_1}$.

Les cases blanches correspondent à des mots vierges, constitués de bits de bourrage. Les mots vierges ne comprennent pas d'information, et permettent de compléter une trame de données dans le cas où elle serait incomplète, par exemple en début de transmission.

Les mots des trames de données d'entrée Te sont ainsi entrelacés entre eux pour former les premières trames de données entrelacées T1.

Le deuxième entrelaceur 22 reçoit successivement les premières trames de données entrelacées T1 lors d'une étape S104. En particulier, les premières trames de données entrelacées T1 reçues par le deuxième entrelaceur 22 sont identiques à celles émises par le premier entrelaceur 21, et n'ont pas été modifiées par un composant électronique.

Le deuxième entrelaceur 22 traite les deuxièmes trames de données entrelacées T2 lors d'une étape S106. L'étape S106 comprend une sous-étape S1062 et une sous-étape S1064.

Lors de la sous-étape S1062, le deuxième entrelaceur 22 sépare les premières trames de données entrelacées T1 en mots de taille SW2. Le fait que le deuxième entrelaceur 22 soit convolutif impose que la taille ST2 des deuxièmes trames de données entrelacées T2 soit égale à un multiple de $\pi2$.

Dans l'exemple de la figure 3, les mots sont de taille SW2=4 bits, autrement dit, chaque mot est formé de quatre bits. Ainsi, la taille SW2 des mots est égale à la taille des premières trames de données entrelacées T1, en bits, soit SW2=ST1×SW1, SW1 étant égal à 1.

Lors de la sous-étape S1064, les mots formés par le deuxième entrelaceur 22 sont envoyés dans les branches du deuxième entrelaceur 22, qui comprend $\pi2$=2 branches. Le deuxième entrelaceur 22 fonctionne de la même manière que le premier entrelaceur 21, avec les paramètres ST2 et $\pi2$. Ainsi, la première branche ne retarde pas les mots, et la deuxième branche retarde les mots d'un retard $z^{-S_{T2}/\pi_2}$. Ainsi, dans l'exemple de la figure 3, le premier mot formé par le deuxième entrelaceur 22, qui est la première trame de données entrelacées T1, devient le premier mot de la trame de données entrelacées T2, le deuxième mot, qui est la trame de données entrelacées T1 suivante, devient le deuxième mot de la deuxième trame de données entrelacées T2 suivante, le troisième mot devient le premier mot de la deuxième trame de données entrelacées T2 encore suivante, etc.

Les mots formés par le deuxième entrelaceur 22 à partir des premières trames de données entrelacées T1 sont ainsi entrelacés entre eux.

Des mots uniques sont insérés entre les deuxièmes trames de données entrelacées T2 par l'unité de synchronisation 24, et les bits des deuxièmes trames de données entrelacées T2 sont associés à des symboles modulés via l'unité de génération 26 à l'étape S108. Puis le signal est émis par le module d'émission 18 lors de l'étape S110, par exemple sous la forme d'un signal optique So. Le signal optique So est représentatif des deuxièmes trames de données entrelacées T2.

Ainsi, le signal optique So est représentatif des données numériques d'entrée De, qui sont entrelacées afin d'être réparties dans le signal optique So.

A l'étape S112, le signal optique So est reçu par le module de réception 42 et converti en trames de données reçues Tr. Avantageusement, lors de l'étape S112, le signal optique So est démodulé par le module de réception 42, l'unité de restitution 46 restitue, ou convertit les symboles démodulés en rapport de vraisemblance codé sur $Q_{LLR}$ bits, et l'unité de synchronisation 48 élimine les mots uniques insérés par l'unité de synchronisation 24, et forme les trames de données reçues Tr et un signal de début de trame, afin de synchroniser les trames de données reçues Tr.

Avantageusement, lors de l'étape S112, chaque rapport de vraisemblance, ou LLR, reçu, qui correspond à un bit dans les deuxièmes trames de données entrelacées T2, est codé sur $Q_{LLR}$ bits. Ainsi, chaque LLR reçu est encodé dans les trames de données reçues Tr sous la forme d'un symbole comprenant $Q_{LLR}$ bits.

Le premier désentrelaceur 51 traite les trames de données Tr, reçues successivement de l'unité de synchronisation 48 lors d'une étape de traitement S114. L'étape de traitement S114 comprend une sous-étape de séparation S1142 et une étape de désentrelacement S1144.

Lors de la sous-étape de séparation S1142, les trames de données reçues Tr sont séparées en mots de taille SW2 symboles de $Q_{LLR}$ bits, c'est-à-dire en mots de SW2×$Q_{LLR}$ bits. Les trames de données reçues Tr sont telles qu'elles peuvent être séparées en ST2 mots de même taille, ST2 étant un multiple de $\pi2$, ainsi qu'indiqué précédemment. Dans l'exemple des figures 3 à 5, les trames de données reçues Tr peuvent être séparées en ST2=2 mots contenant SW2 symboles de $Q_{LLR}$ bits.

Lors de la sous-étape S1144, les mots formant une trame de données reçues Tr sont successivement envoyés dans les branches 60a et 60b du désentrelaceur, le choix de la branche étant imposé par le pointeur 62, ainsi que pour l'entrelaceur 51. Le pointeur d'entrée 62 parcourt successivement chaque branche, avantageusement en commençant par la branche 60b, puis la branche 60a. Ainsi, le premier mot d'une trame de données reçue Tr est envoyé dans la branche 60b, et le deuxième dans la branche 60a.

Lorsque le premier mot est envoyé dans la branche 60b, il est retardé d'un retard égal à $z^{-S_{T2}/\pi_2}$ et lorsque le deuxième mot est envoyé dans la branche 60a, il n'est pas retardé.

Le pointeur de sortie 64 lit les mots sur les branches 60a et 60b, et le déplacement du pointeur de sortie 64 est synchronisé avec celui du pointeur d'entrée 62. Ainsi, l'entrelaceur 51 désentrelace les mots en les agençant de manière inverse à l'entrelacement effectué par le deuxième entrelaceur 22. Les mots formés par le premier désentrelaceur 51 sont ainsi désentrelacés, formant ainsi des premières trames de données désentrelacées Td1, dont les données sont organisées de manière similaire aux premières trames de données entrelacées T1, mis à part le fait que chaque mot est formé de symboles comprenant $Q_{LLR}$ bits, et non pas de symboles d'un bit.

En pratique, sur une des applications industrielles visées, un mot formé par le premier désentrelaceur 51 par séparation d'une trame de données reçues Tr comprend SW2=32768 symboles, chaque symbole comprenant chacun $Q_{LLR}$=4 bits. Ainsi, la taille des mots des premières trames de données désentrelacées Td1 est de l'ordre de ST1x$Q_{LLR}$=SW2x$Q_{LLR}$=32768x4=131072 bits. D'autres valeurs sont bien entendu possibles, en fonction des applications.

Une vitesse de transfert des mémoires DDR est maximale pour des données à transférer dont la taille est supérieure à 100 kbit, pour les mémoires DDR choisies pour une des applications envisagées. Ainsi, lors du désentrelacement par le premier désentrelaceur 51, la taille des mots à envoyer dans les branches 60a à 60d, autrement dit, à enregistrer et à lire en mémoire, est suffisante pour assurer un fonctionnement de la mémoire DDR 57 à une vitesse optimale.

Les premières trames de données désentrelacées Td1 sont reçues successivement par le deuxième désentrelaceur 52 lors d'une étape S116. En particulier, les premières trames de données désentrelacées Td1 reçues par le deuxième désentrelaceur 52 sont identiques à celles émises par le premier désentrelaceur 51, et n'ont pas été modifiées par un composant électronique.

Le deuxième désentrelaceur 52 traite les premières trames de données désentrelacées Td1 lors d'une étape de traitement S118, qui comprend une sous-étape de séparation S1182 et une sous-étape de désentrelacement S1184.

Lors de la sous-étape S1182, le deuxième désentrelaceur 52 sépare les premières trames de données désentrelacées Td1 en mots de SW1 symboles de $Q_{LLR}$ bits. Les premières trames de données désentrelacées Td1 sont formées de ST1 mots de même taille, ST1 étant un multiple de $\pi1$, lors de l'étape S1182.

Lors de la sous-étape de désentrelacement S1184, les mots formés par le deuxième désentrelaceur 52 sont envoyés dans les branches du deuxième désentrelaceur 52, qui comprend $\pi1=4$ branches. Le fonctionnement du deuxième désentrelaceur 52 est similaire à celui du premier désentrelaceur 51, avec les paramètres ST1 et $\pi1$. Ainsi, le premier mot est envoyé dans la branche qui retarde les mots de quatre fois le retard $z^{-S_{T1}/\pi_1}$, le deuxième mot, dans la branche qui retarde de trois fois le retard $z^{-S_{T1}/\pi_1}$, etc. Cela permet d'effectuer l'opération inverse de celle réalisée par le premier entrelaceur 21, et de désentrelacer les mots formés par séparation des premières trames de données désentrelacées Td1 de telle sorte à former les deuxièmes trames de données désentrelacées Td2, dont les mots sont organisés de manière similaire à ceux des trames de données d'entrée Te.

Les deuxièmes trames de données désentrelacées Td2 sont reçues et converties par l'unité de décodage canal 54 lors d'une étape S120. Avantageusement, en implémentant des codes de correction d'erreurs, par exemple des codes LDPC, l'unité de décodage canal 54 génère des données numériques de sortie Ds représentatives, et avantageusement, identiques, au données numériques d'entrée De.

Utiliser deux entrelaceurs successifs 21, 22, et deux désentrelaceurs successifs 51 et 52 permet d'entrelacer finement les données, afin d'éviter, en cas d'évanouissement, de perdre une quantité trop importante de bits d'une trame, tout en les répartissant sur des durées importantes, ce qui permet de supporter des évanouissements de durée plus longue. De plus, avoir deux désentrelaceurs 51, 52 successifs permet d'optimiser l'utilisation de la mémoire DDR, puisque la taille des données à transférer dans la mémoire DDR est supérieure à 100kbits. La mémoire DDR fonctionne alors à sa vitesse maximale, ce qui permet d'assurer un débit optimal de traitement des données.

En variante, les mémoires 57 et/ou 34 sont réalisées à partir de mémoires fonctionnant en mode rafale, c'est-à-dire qu'une vitesse d'accès à la mémoire est maximale lorsque les données sont transmises par paquets dépassant une taille prédéfinie, par exemple 100 kbit, et la taille des mots formés par séparation des premières trames de données désentrelacées Td1 par le premier désentrelaceur 51 et/ou la taille des mots formés par séparation des premières trames de données entrelacées T1 est supérieure à cette taille prédéfinie.

Toute caractéristique décrite pour un mode de réalisation ou une variante dans ce qui précède peut être mise en œuvre pour les autres modes de réalisation et variantes décrits précédemment, pour autant que techniquement faisable.

**Revendications**

1. Emetteur (12) de signaux (So) représentatifs de données numériques d'entrée (De), comprenant un module de traitement numérique (16) comprenant :

   - un premier entrelaceur (21) configuré pour recevoir successivement des trames de données d'entrée (Te), représentatives des données numériques d'entrée (De), pour les séparer en mots, et pour entrelacer les mots des trames de données d'entrée (Te) entre eux selon une première logique afin de former des premières trames de données entrelacées (T1) ; et
   - un deuxième entrelaceur (22), configuré pour recevoir les premières trames de données entrelacées (T1), pour les séparer en mots et pour entrelacer les mots des premières trames de données entrelacées (T1) entre eux selon une deuxième logique afin de former des deuxièmes trames de données entrelacées (T2),

   l'émetteur (12) comprenant en outre un module d'émission (18) configuré pour émettre les signaux (So),

   dans lequel la première et la deuxième logique sont des logiques de convolution, et dans lequel chaque entrelaceur (21, 22) a les paramètres suivants :

      - un nombre de branches (30a, 30b, 30c, 30d) prédéterminé définissant une profondeur d'entrelacement ($\pi1$, $\pi2$) ; et
      - une taille (ST1, ST2) des trames de données entrelacées (T1, T2) émises par l'entrelaceur (21, 22), exprimée en nombre de mots, et

dans lequel le deuxième entrelaceur (22) est configuré pour séparer les premières trames de données entrelacées (T1) émises par le premier entrelaceur (21) en mots dont une taille (SW2), exprimée en bits, égale à la taille (ST1) des premières trames de données entrelacées (T1), exprimée en bits.

2. Emetteur (12) selon la revendication 1, dans lequel les deux entrelaceurs (21, 22) ont une profondeur d'entrelacement ($\pi$1, $\pi$2) égale.

3. Emetteur (12) selon l'une quelconque des revendications 1 à 2, dans lequel le deuxième entrelaceur (22) comprend une mémoire (34), une taille de la mémoire ($S_{DDR}$) en nombre de bits étant égale à la moitié du produit entre la profondeur du deuxième entrelaceur ($\pi$2), la taille des deuxièmes trames de données entrelacées (ST2) et la taille (SW2) de chaque mot formant les deuxièmes trames de données entrelacées (T2) en nombre de bits.

4. Emetteur (12) selon la revendication 3, dans lequel le deuxième entrelaceur (22) comprend une mémoire (34) de type débit de données double.

5. Emetteur (12) selon l'une quelconque des revendications 1 à 4, dans lequel chaque entrelaceur (21, 22) est configuré pour séparer les trames de données (Te, T1) qu'il reçoit en mots formés d'au moins un bit.

6. Emetteur (12) selon l'une quelconque des revendications 1 à 5, le module de traitement numérique (16) comprenant en outre une unité de codage canal (20), configurée pour recevoir les données numériques d'entrée (De), et pour convertir les données numériques d'entrée (De) en trames de données d'entrée (Te), les trames de données d'entrée (Te) étant représentatives des données numériques d'entrée (De).

7. Récepteur (14) comprenant un module de réception (42) configuré pour recevoir un signal (So) émis par un émetteur (12) selon l'une quelconque des revendications 1 à 6, le récepteur (14) comprenant en outre un module de traitement numérique (44) comprenant :

- un premier désentrelaceur (51), configuré pour recevoir successivement des trames de données reçues (Tr), les trames de données reçues (Tr) étant représentatives du signal (So) émis par l'émetteur (12), pour séparer les trames de données reçues (Tr) en mots et pour désentrelacer les mots des trames de données reçues (Tr) selon la deuxième logique afin de former des premières trames de données désentrelacées (Td1) ;
- un deuxième désentrelaceur (52), configuré pour recevoir successivement les premières trames de données désentrelacées (Td1), pour séparer les premières trames de données désentrelacées (Td1) en mots et pour désentrelacer les mots des premières trames de données désentrelacées (Td1) selon la première logique afin de former des deuxièmes trames de données désentrelacées (Td2).

8. Chaîne de transmission (10) comprenant un émetteur (12) selon l'une quelconque des revendications 1 à 6 et un récepteur (14) selon la revendication 7.

9. Procédé de transmission de données, mis en oeuvre par une chaîne de transmission (10) selon la revendication 8, le procédé comprenant au moins les étapes suivantes :

- traitement (S102), par le premier entrelaceur (21), des trames de données d'entrée (Te) reçues successivement, le traitement (S102) comprenant une sous étape de séparation (S1022) des trames de données d'entrée (De) en mots et une sous étape d'entrelacement (S1024) des mots des trames de données d'entrée (De) entre eux selon la première logique pour former les premières trames de données entrelacées (T1) ;
- réception (S104) successive par le deuxième entrelaceur (22), des premières trames de données entrelacées (T1) ;
- traitement (S106), par le deuxième entrelaceur (22), le traitement (S106) comprenant une sous-étape de séparation (S1062) des premières trames entrelacées (T1) en mots et une sous-étape d'entrelacement (S1064) des mots des premières trames de données entrelacées (T1) entre eux selon la deuxième logique pour former les deuxièmes trames de données entrelacées (T2) ;
- émission (S110) par le module d'émission (18) du signal (So) représentatif des données numériques d'entrée (De) ;
- réception (S112) par le module de réception (42) du signal (So) et conversion en trames de données reçues (Tr) ;
- traitement (S114), par le premier désentrelaceur (51), des trames de données reçues (Tr) successivement, le traitement (S114) comprenant une sous-étape de séparation (S1142) des trames de données reçues (Tr) en mots et une sous-étape de désentrelacement (S1144) des mots des trames de données reçues (Tr) selon la deuxième logique pour former les premières trames de données désentrelacées (Td1) ;

- réception (S116) successive par le deuxième désentrelaceur (52) des premières trames de données désentrelacées (Td1) ; et

- traitement (S118), par le deuxième désentrelaceur (52), des premières trames de données désentrelacées (Td1), le traitement (S118) comprenant une sous-étape de séparation (S1182) des premières trames désentrelacées (Td1) en mots et une sous-étape de désentrelacement (S1184) des mots des premières trames de données désentrelacées (Td1) selon la première logique pour former les deuxièmes trames de données désentrelacées (Td2).

14

10

So

-12-

FIG.1

FIG.2

FIG.3

$$Z^{-1} \times ST1/\pi 1$$

$$Z^{-(\pi 1-2) \times ST1/\pi 1}$$

$$Z^{-(\pi 1-1) \times ST1/\pi 1}$$

$$Z^{-1} \times ST2/\pi 2$$

FIG.4

FIG.5

Europäisches Patentamt
European Patent Office
Office européen des brevets

## RAPPORT DE RECHERCHE EUROPEENNE

Numéro de la demande

EP 25 21 0940

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | US 2023/216807 A1 (KLENNER PETER [DE]) 6 juillet 2023 (2023-07-06) | 7 | INV. H04L1/00 H03M13/27 |
| A | * alinéa [0035] - alinéa [0045] * * alinéa [0079] - alinéa [0120]; figures 5, 6a,6b,6c,6d,6e,6f,6g * * alinéa [0121] - alinéa [0140]; figure 7 * | 1-6,8,9 | |
| | ----- | | |
| X | DVB ORGANIZATION: "En300744.V1.1.1.pdf", DVB, DIGITAL VIDEO BROADCASTING, C/O EBU - 17A ANCIENNE ROUTE - CH-1218 GRAND SACONNEX, GENEVA - SWITZERLAND, 3 octobre 2003 (2003-10-03), XP017830695, | 7 | |
| A | * page 10 * * Section "4.3.4 Inner interleaving"; page 14 - page 20; figures 6, 7a, 7b * | 1-6,8,9 | |
| | ----- | | |
| X | US 7 519 088 B2 (ZENITH ELECTRONICS LLC [US]) 14 avril 2009 (2009-04-14) | 7 | |
| A | * colonne 4, ligne 18 - ligne 57; figure 1 * * revendications 1-6 * * figure 3 * | 1-6,8,9 | DOMAINES TECHNIQUES RECHERCHES (IPC) H04L H03M |
| | ----- | | |

Le présent rapport a été établi pour toutes les revendications

| Lieu de la recherche | Date d'achèvement de la recherche | Examinateur |
|---|---|---|
| Munich | 17 mars 2026 | Courville, Nicolas |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
........................................................................
& : membre de la même famille, document correspondant

EPO FORM 1503 03.82 (P04C02)

**ANNEXE AU RAPPORT DE RECHERCHE EUROPEENNE
RELATIF A LA DEMANDE DE BREVET EUROPEEN NO.**

EP 25 21 0940

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

17-03-2026

| Document brevet cité au rapport de recherche | Date de publication | Membre(s) de la famille de brevet(s) | Date de publication |
|---|---|---|---|
| US 2023216807 A1 | 06-07-2023 | CN 112134575 A | 25-12-2020 |
| | | CN 112217523 A | 12-01-2021 |
| | | KR 20170063425 A | 08-06-2017 |
| | | KR 20220015493 A | 08-02-2022 |
| | | KR 20220162814 A | 08-12-2022 |
| | | US 2022393991 A1 | 08-12-2022 |
| | | US 2023216807 A1 | 06-07-2023 |
| | | WO 2016051687 A1 | 07-04-2016 |
| US 7519088 B2 | 14-04-2009 | AR 029062 A1 | 04-06-2003 |
| | | AU 4948401 A | 30-10-2001 |
| | | BR 0110135 A | 07-01-2003 |
| | | CA 2406136 A1 | 25-10-2001 |
| | | CN 1423883 A | 11-06-2003 |
| | | HK 1055862 A1 | 21-01-2004 |
| | | KR 20020093930 A | 16-12-2002 |
| | | MX PA02010200 A | 23-05-2003 |
| | | TW 508948 B | 01-11-2002 |
| | | US 2002001349 A1 | 03-01-2002 |
| | | US 2004160991 A1 | 19-08-2004 |
| | | US 2005152411 A1 | 14-07-2005 |
| | | US 2008089365 A1 | 17-04-2008 |
| | | US 2008089415 A1 | 17-04-2008 |
| | | US 2008089430 A1 | 17-04-2008 |
| | | US 2008092012 A1 | 17-04-2008 |
| | | US 2008107171 A1 | 08-05-2008 |
| | | US 2009024897 A1 | 22-01-2009 |
| | | US 2009180535 A1 | 16-07-2009 |
| | | US 2012033740 A1 | 09-02-2012 |
| | | WO 0178496 A2 | 25-10-2001 |

EPO FORM P0460

Pour tout renseignement concernant cette annexe : voir Journal Officiel de l'Office européen des brevets, No.12/82